Europäisches Patentamt

**European Patent Office**

**Office européen des brevets**

(11) Numéro de publication: **0 166 627**
**A1**

(12) # DEMANDE DE BREVET EUROPEEN

(21) Numéro de dépôt: 85400599.8

(22) Date de dépôt: 27.03.85

(51) Int. Cl.⁴: **H 01 R 4/48,** H 01 R 9/07, H 01 R 23/66, H 01 R 23/68, H 01 R 23/72

(30) Priorité: 30.03.84 FR 8405025

(43) Date de publication de la demande: 02.01.86 Bulletin 86/1

(84) Etats contractants désignés: **AT BE CH DE GB IT LI LU NL SE**

(71) Demandeur: **BOUSSOIS S.A., 126-130 rue Jules Guesde, F-92302 Levallois-Perret (FR)**

(72) Inventeur: **de Moncuit, Frédéric, 4 Impasse Norlet, F-75011 Paris (FR)**

(74) Mandataire: **Bouju, André, 38 Avenue de la Grande Armée, F-75017 Paris (FR)**

(54) **Connexion d'un circuit électrique sur un support rigide avec un circuit électrique sur au moins un support souple.**

(57) Selon l'invention, on réalise une connexion d'un circuit électrique (2) sur un support rigide (1) avec un circuit électrique (5) sur au moins un support souple (4), le circuit (2) sur le support rigide (1) et le circuit (5) sur le support souple (4) apparaissant à la surface du support (1, 4) sur une partie (3, 6) au moins du circuit (2, 5), les parties apparentes (3, 6) de chacun du circuit (2, 5) étant mises en regard et serrées l'une contre l'autre par une pince (8).

Selon une version avantageuse, le support souple (4) enveloppe le bord du support rigide (1) et est maintenu en place provisoirement par un adhésif (14).

## "Connexion d'un circuit électrique sur un support rigide avec un circuit électrique sur au moins un support souple"

La présente invention concerne une connexion d'un circuit électrique sur un support rigide avec un circuit électrique sur au moins un support souple.

Il est bien connu de réaliser des circuits électriques sur des supports rigides en particulier dans le cas des circuits imprimés ou d'écrans tactiles. Les circuits sur différents supports rigides sont généralement reliés entre eux ou à d'autres composants du dispositif électronique par des circuits sur un support souple. Pour la connexion du circuit électrique sur le support rigide à un circuit électrique sur un support souple, il est généralement nécessaire de prévoir un connecteur en bordure du support rigide et du support souple. Ce connecteur comprend un organe mâle comportant une série de broches chacune fixée à une ligne du circuit porté par le support rigide au moyen d'une soudure, avec éventuellement un percement du support rigide pour fixer l'organe de connexion par des vis ou des rivets passant à travers le support rigide. De la même façon, un organe femelle est fixé à une extrémité du circuit souple et les organes mâles et femelles sont mis en regard pour réaliser la connexion.

Dans certains cas toutefois, il est difficilement possible de réaliser une connexion du type qui vient d'être mentionné, en particulier lorsque le support rigide ne peut être percé. C'est le cas pour un certain nombre d'écrans tactiles à effet capacitif ou résistif dont le support rigide est une matière minérale, comme le verre ou la vitro-céramique. Dans ce cas, il a été proposé de maintenir le support souple associé au support rigide par des moyens de pincement. Le document US 4 019 798 décrit en particulier une connexion dans laquelle l'extrémité d'un circuit porté par un support souple apparaît à la surface de ce support et est maintenue appliquée contre un circuit porté par un support

2    0166627

rigide au moyen d'une ou plusieurs pinces en forme de U.

Dans les connexions existantes, la partie du circuit sur le support souple appliquée contre le circuit sur le support rigide est toujours disposée à une extrémité du support souple et si l'on désire effectuer des connexions entre les lignes du circuit sur le support souple, celles-ci doivent être réalisées à l'extrémité opposée à celle qui est maintenue contre le support rigide. Le support souple doit donc nécessairement comporter le même nombre de lignes que le support rigide. Dans le cas d'un support rigide comprenant un grand nombre de lignes, on a donc un support souple de grande largeur et d'un encombrement important.

Un but de la présente invention est de proposer des moyens permettant d'augmenter les possibilités de connexions entre les lignes du circuit sur le support souple.

En vue de la réalisation de ce but, on prévoit selon l'invention, une connexion d'un circuit électrique sur support rigide avec un circuit électrique sur au moins un support souple, le circuit sur le support rigide et le circuit sur le support souple apparaissant à la surface du support sur une partie au moins du circuit, les parties apparentes de chacun des circuits étant en regard et serrées l'une contre l'autre par un moyen de pincement, caractérisée en ce que le circuit sur le support souple s'étend de part et d'autre de la partie de ce circuit apparaissant à la surface du support souple.

Ainsi, la connexion avec le circuit du support rigide est effectuée en un point intermédiaire du circuit sur le support souple et il est donc possible de prévoir sur le support souple un circuit comprenant des liaisons différentes de part et d'autre de la connexion avec le circuit sur le support rigide.

Selon une version avantageuse de l'invention, une partie du support souple s'étendant au-delà de la partie du circuit apparaissant à la surface du support souple est repliée sur elle-même et maintenue par les moyens de pincement. Ainsi, le support rigide reste entièrement dégagé.

Selon un autre aspect de l'invention, le support souple enveloppe le bord du support rigide et comporte un adhésif en regard de la face du support rigide opposée à la face sur laquelle le circuit sur le support rigide présente une partie apparente. Ainsi, l'adhésif permet la fixation provisoire du support souple sur le support rigide avant la mise en place des moyens de pincement et donc un positionnement précis du support souple par rapport au support rigide.

Selon encore un autre aspect de l'invention, on prévoit un premier support souple sur lequel la partie de circuit apparaissant à la surface s'étend de part et d'autre du bord du support rigide, et un circuit sur un second support souple qui est mis en contact avec la partie de circuit sur le premier support souple apparaissant à la surface de celui-ci en regard de la face du support rigide opposée à celle sur laquelle apparaît le circuit porté par le support rigide. Ainsi, le circuit porté par le premier support souple est en contact avec le circuit porté par le support rigide et le circuit porté par le second support souple.

D'autres caractéristiques et avantages de l'invention résulteront encore de la description ci-après d'exemples non limitatifs en référence aux dessins annexés dans lesquels:

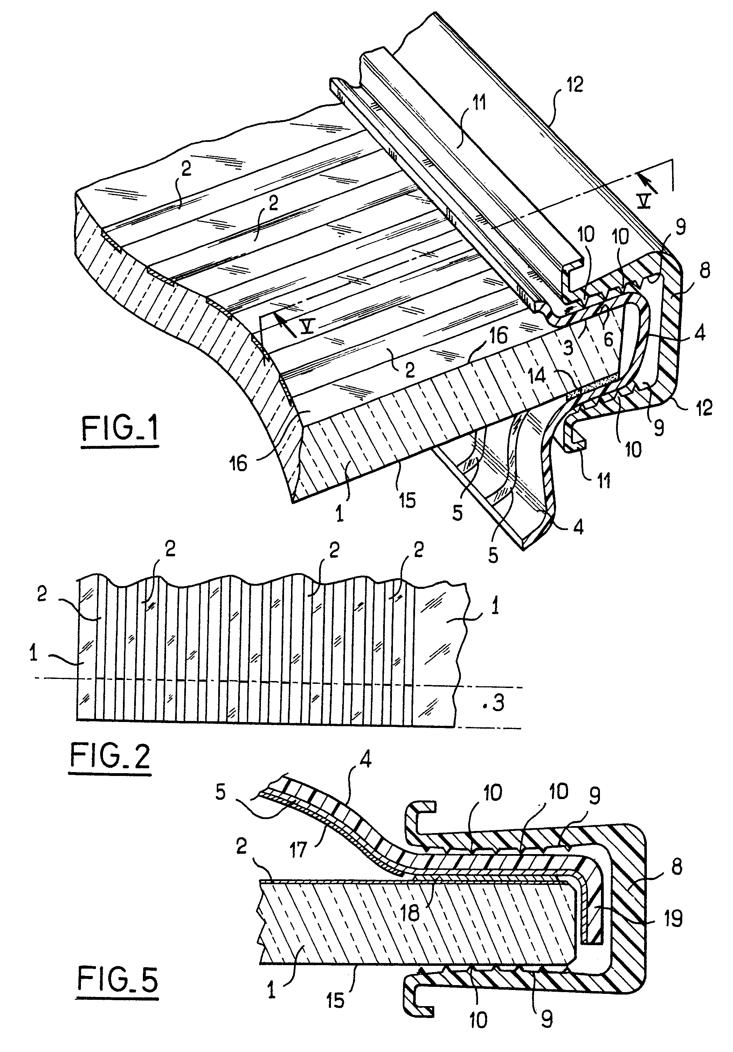

. la figure 1 est une vue en perspective partielle agrandie d'un premier mode de réalisation de l'invention;

. la figure 2 est une vue de dessus partielle du circuit sur le support rigide;

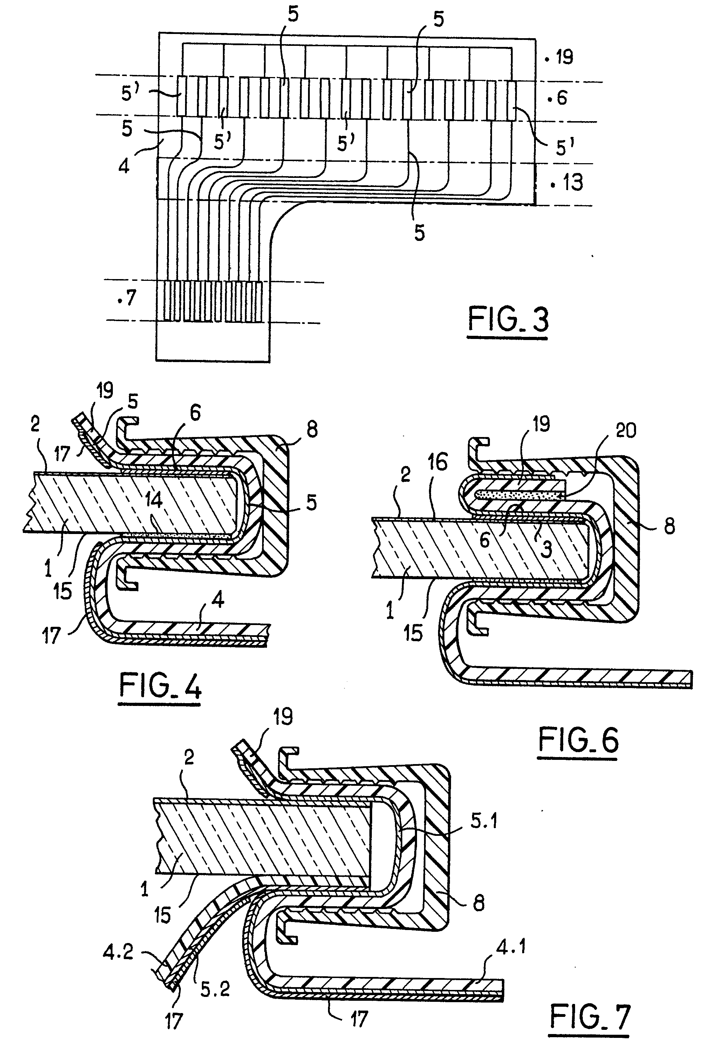

. la figure 3 est une vue de dessus du circuit sur le support souple posé à plat;

. la figure 4 est une vue en coupe suivant
le plan V-V de la figure 1;

. la figure 5 est une vue en coupe suivant
le plan V-V de la figure 1, d'un second mode de réalisation de connexion selon l'invention;

. la figure 6 est une variante de réalisation
de la connexion selon le premier mode de réalisation;

. la figure 7 est une vue en coupe suivant le
plan V-V de la figure 1 d'un troisième mode de réalisation de l'invention.

En référence plus particulièrement aux figures 1 à 4, le circuit électrique sur un support rigide
1, ici un écran tactile à effet résistif, comprend une
série de lignes conductrices 2 apparaissant à la surface du support rigide 1. Dans la zone de bord 3
délimitée sur la figure 2 par un trait mixte, les
lignes conductrices 2 comportent une zone conductrice
privilégiée où les pistes sont de préférence recouvertes par un dépôt conducteur, comme de l'argent ou du
nickel déposé sous forme d'une peinture, d'un émail ou
par pulvérisation selon des techniques connues en
elles-mêmes.

Un circuit électrique sur un support souple 4
comporte une série de pistes conductrices 5 comportant
des zones de contact 6 et 7 où les pistes conductrices
5 apparaissent à la surface du support souple. Par
exemple, le circuit souple est réalisé d'une façon
connue en soi, à partir d'une feuille de polyester ou
de polyamide d'une épaisseur de l'ordre de 50 à
$100.10^{-6}$ m. sur laquelle est déposée une série de pistes conductrices 5 en cuivre d'une épaisseur de l'ordre de $35.10^{-6}$ m. La face du support souple 4 sur laquelle sont déposées les lignes conductrices 5 est recouverte d'un vernis isolant diélectrique, sauf dans les zones de contact 6 et 7 où les conducteurs 5 apparaissent à la surface du support.

Bien entendu, au moins dans les zones de contact 3 et 6, les lignes conductrices 2 ont le même écartement que les pistes conductrices 5.

On remarque que le circuit sur le support souple 4 s'étend de part et d'autre de la partie 6 où le circuit apparaît à la surface du support 4. Ainsi, il est possible de relier entre elles certaines pistes 5' du circuit 5 sans interférer avec les autres pistes. Dans le cas particulier représenté, la moitié des pistes sont reliées entre elles, tandis que les autres pistes sont intercalées entre les pistes reliées.

Pour réaliser la connexion selon l'invention, les parties apparentes de chacun des circuits 2 et 5 sont mises en regard et serrées l'une contre l'autre par une pince 8, de préférence une pince ayant une forme de profilé en U, comportant sur sa face interne 9 des nervures longitudinales 10 espacées les unes des autres qui font saillie par rapport à la surface interne et assurent une pression locale privilégiée des lignes conductrices 2 avec les pistes conductrices 5. Selon une réalisation préférée, les bords de la pince 8 sont retournés pour former des rebords 11 sous lesquels peuvent être engagées, d'une façon connue en soi, des plaquettes utilisées pour former un levier autour des coins 12 de la pince 8 et ouvrir le profilé pour sa mise en place.

Lors de la mise en place de la connexion, les lignes conductrices 2 sur le support rigide 1 sont ainsi également reliées entre elles, ce qui permet, par exemple, dans le cas représenté d'alimenter une ligne conductrice 2 sur deux à partir d'une seule source de tension. Dans ce cas, la partie 19 du support souple 4 qui s'étend au-delà de la partie 6 de circuit apparaissant à la surface du support souple 4 peut être soit laissée libre comme illustré sur la figure 4 ou la figure 5, soit repliée sur elle-même comme illustré sur la figure 6 et maintenue par la pince 8. Avant la mise en place de la pince, la partie repliée est, par exemple, maintenue en place au moyen d'une bande d'adhésif double face 20.

Selon une version avantageuse de la pince, illustrée par la figure 5, la surface interne 9 des ailes du profilé est convexe. Ainsi, un bon appui des nervures 10 est obtenu même lorsque le bord du support rigide 1 n'est pas rectiligne, au moins l'une des nervures 10 étant en appui sur le support souple au niveau du contact entre les zones 3 et 6.

Selon le mode de réalisation représenté sur les figures 1, 4 et 6, le support souple 4 comporte une couche d'adhésif 14 qui s'étend selon une bande 13 sensiblement parallèle à la zone 6 où les pistes conductrices 5 apparaissent à la surface du support souple 4.

Lors de la mise en place de la connexion, l'adhésif 14 est mis en regard de la face 15 du support rigide 1 qui est opposée à la face 16 sur laquelle le circuit 2 présente une partie apparente 3. Ainsi, lors de la mise en place, le support souple 4 est fixé provisoirement au support rigide 1, ce qui permet à l'opérateur de replier le support souple 4 sur la face 16 du support rigide 1 afin de mettre en contact les pistes conductrices 5 et 5' avec les lignes conductrices 2. Dans ce mode de réalisation, le support souple 4 enveloppe le bord du support rigide 1. Si la pince 8 est alors mise en place en l'ouvrant d'une quantité légèrement inférieure à l'épaisseur de l'ensemble, les nervures 10 frottent sur la surface du support souple 4, de part et d'autre du support rigide 1, de sorte que le support souple 4 ne peut s'échapper et la connexion est correctement réalisée, même lors d'une manoeuvre imparfaite.

La zone 7 du support souple 4 peut être reliée d'une façon analogue à celle qui vient d'être décrite pour la zone 6 à un circuit sur un support rigide, par exemple un circuit imprimé, ou d'une façon connue en soi à un connecteur encartable avec une autre partie du circuit.

La figure 5 illustre une variante de réalisation dans laquelle on souhaite que le support souple 4 s'étende du même côté que les lignes conductrices 2 sur le support rigide 1. Dans ce cas, les pistes conductrices 5 sont recouvertes d'un vernis isolant 17, sauf dans la zone où les pistes conductrices 5 sont en contact avec les lignes conductrices 2, elles-mêmes recouvertes dans cette zone avec un dépôt conducteur 18. Les parties de circuit apparaissant à la surface du support rigide 1 et du support souple 4 sont simplement mises en contact, puis la pince 8 est mise en place avec sa branche inférieure s'appuyant directement sur la face 15 du support rigide 1.

On a illustré sur la figure 7, une variante de réalisation pour relier un circuit sur un support rigide 1 avec un circuit sur un premier support souple 4.1 et un circuit sur un second support souple 4.2. Dans ce cas, la partie de circuit 5.1 apparaissant à la surface du premier support souple 4.1 s'étend de part et d'autre du bord du support rigide 1 et le circuit 5.2 sur le second support souple 4.2 est en contact avec la partie de circuit 5.1 sur le premier support souple 4.1 apparaissant à la surface de celui-ci en regard de la face 15 du support rigide opposée à celle sur laquelle apparaît le circuit 2 porté par le support rigide.

Ainsi, le circuit 5.1 sur le premier support souple 4.1 se trouve relié au circuit 2 sur le support rigide 1 d'une façon analogue à celle qui a été décrite en liaison avec la figure 1, tandis que le circuit 5.2 sur le second support souple 4.2 se trouve relié au circuit 5.1 sur le premier support souple 4.1. Les signaux, transmis par le circuit 2 peuvent être ainsi transférés à deux utilisations différentes par les circuits 5.1 et 5.2, tout en utilisant une seule connexion.

Bien entendu, l'invention n'est pas limitée aux modes de réalisation décrits ci-dessus et on peut y apporter des variantes d'exécution.

En particulier, on peut maintenir les parties de circuits 2 et 5 apparaissant respectivement à la surface du support rigide 1 et du support souple 4 par tout moyen de pincement.

De même, l'adhésif 14 servant à la mise en place provisoire du support souple 4 peut être prévu initialement sur le support rigide 1 au lieu du support souple 4 et peut être disposé en tout point qui pourra sembler approprié pour une mise en place aisée.

0166627

REVENDICATIONS

1. Connexion d'un circuit électrique (2) sur un support rigide (1) avec un circuit électrique (5) sur au moins un support souple (4), le circuit (2) sur le support rigide (1) et le circuit (5) sur le support souple (4) apparaissant à la surface du support (1, 4) sur une partie (3, 6) au moins du circuit (2, 5), les parties apparentes (3, 6) de chacun des circuits (2, 5) étant en regard et serrées l'une contre l'autre par un moyen de pincement (8), caractérisée en ce que le circuit (5) sur le support souple (4) s'étend de part et d'autre de la partie (6) de ce circuit apparaissant à la surface du support souple (4).

2. Connexion conforme à la revendication 1, caractérisée en ce qu'une partie (19) du support souple (4) s'étendant au-delà de la partie (6) du circuit apparaissant à la surface du support (4) est repliée sur elle-même et maintenue par les moyens de pincement (8).

3. Connexion conforme à la revendication 1 ou la revendication 2, dans laquelle le support souple (4) enveloppe un bord du support rigide (1), caractérisée en ce que le support souple (4) comporte un adhésif (14) en regard de la face (15) du support rigide (1) opposée à la face (16) sur laquelle le circuit (2) sur le support rigide présente une partie apparente (3).

4. Connexion conforme à la revendication 1 ou à la revendication 2, caractérisée en ce qu'une partie (6) de circuit (5.1) apparaissant à la surface d'un premier support souple (4.1) s'étend de part et d'autre d'un bord du support rigide (1) et en ce qu'un circuit (5.2) sur un second support souple (4.2) est en contact avec la partie de circuit (5.1) sur le premier support souple (4.1) apparaissant à la surface de celui-ci en regard de la face (15) du support rigide (1) opposée à celle (16) sur laquelle apparaît le circuit (2) porté par le support rigide (1).

5. Connexion conforme à l'une des revendications 1 à 4, caractérisée en ce que les moyens de pincement comportent une pince (8) en forme de U comportant des ailes ayant une surface interne (9) convexe sur laquelle font saillie des nervures longitudinales (10) espacées les unes des autres.

FIG.1

FIG.2

FIG.5

0166627

FIG. 3

FIG. 4

FIG. 6

FIG. 7

0166627
Numéro de la demande

**Office européen des brevets**

# RAPPORT DE RECHERCHE EUROPEENNE

EP 85 40 0599

| | **DOCUMENTS CONSIDERES COMME PERTINENTS** | | |
|---|---|---|---|
| Catégorie | Citation du document avec indication, en cas de besoin, des parties pertinentes | Revendication concernée | CLASSEMENT DE LA DEMANDE (Int. Cl.4) |
| X | US-A-4 111 510  (R.F. ZURCHER) * Abrégé; figure 1; revendication 1 * | 1 | H 01 R    4/48 H 01 R    9/07 H 01 R   23/66 H 01 R   23/68 H 01 R   23/72 |
| A | | 2-5 | |
| X,D | US-A-4 019 798  (E.J. ZIELINSKI) * Figures 1-6; colonne 3, lignes 16-19; colonne 4, lignes 12-22; colonne 5, lignes 29-31 * | 1-5 | |
| A | EP-A-0 070 071  (N.V. PHILIPS) * Figures 2-2a; page 3, lignes 23-30 * | 1-5 | |
| A | US-A-4 416 497  (G.T. BRANDSNESS et al.) * Figures 4,7; revendication 1 * | 1-5 | DOMAINES TECHNIQUES RECHERCHES (Int. Cl.4) |
| A | IBM-TECHNICAL DISCLOSURE BULLETIN, vol. 26, no. 3A, Août 1983; M.S. BILSBACK et al. "Improved Flat flexible cable connector", pages 1152, 1153 * Figure 1 * | 1 | H 01 R    4/00 H 01 R    9/00 H 01 R   13/00 H 01 R   23/00 H 05 K    3/00 |
| X,P | DE-U-8 425 152  (SIEMENS) * Revendication 1; figure * | 1 | |

Le présent rapport de recherche a été établi pour toutes les revendications

| Lieu de la recherche | Date d'achèvement de la recherche | Examinateur |
|---|---|---|
| BERLIN | 12-06-1985 | BRISON O.P. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03.82